# EUROPÄISCHE PATENTSCHRIFT

(11) **EP 1 617 456 B1**
(45) Veröffentlichungstag und Bekanntmachung des Hinweises auf die Patenterteilung: **18.10.2006**
(21) Anmeldenummer: 04012663.3
(22) Anmeldetag: 28.05.2004
(51) Int. Cl.: H01J 37/20, H01L 21/68, C23C 14/56

(54) **Antriebsmechanismus für eine Vakuum-Behandlungsanlage**
Driving mechanism for a vacuum treating system
Mécanisme d'entraînement pour appareil de traitement sous vide

(43) Veröffentlichungstag der Anmeldung: 18.01.2006
(73) Patentinhaber: Applied Films GmbH & Co. KG, 63755 Alzenau (DE)
(72) Erfinder: Lindenberg, Ralph, Dipl.-Ing., 63654 Büdingen (DE); König, Michael, Dipl.-Ing., 60529 Frankfurt/M. (DE); Schüssler, Uwe, Dipl.-Ing., 63743 Aschaffenburg (DE); Bangert, Stefan, Dipl.-Ing., 36396 Steinau (DE)
(74) Vertreter: Zapfe, Hans

(56) Entgegenhaltungen:
- EP-A- 0 136 562
- US-A- 5 407 314
- US-A- 5 709 785
- PATENT ABSTRACTS OF JAPAN Bd. 2002, Nr. 11, 6. November 2002 (2002-11-06) -& JP 2002 200419 A (SHIBAURA MECHATRONICS CORP), 16. Juli 2002 (2002-07-16)
- PATENT ABSTRACTS OF JAPAN Bd. 1995, Nr. 02, 31. März 1995 (1995-03-31) -& JP 06 322542 A (SONY CORP), 22. November 1994 (1994-11-22)

## Beschreibung

Die Erfindung betrifft einen Antriebsmechanismus für eine Vakuum-Behandlungsanlage, durch die mehrere Substrathalter auf einer Umlaufbahn um eine Achse von einer Eintragsschleuse über mindestens eine Behandlungskammer zu einer Austragsschleuse transportierbar sind, wobei im Zentrum der Umlaufbahn eine ortsfeste Tragsäule angeordnet ist, auf der eine drehbare Getriebekammer gelagert ist, auf deren Aussenseiten Steuerstangen für eine Rotation und eine Radialverlagerung der Substrathalter angeordnet sind, wobei in der drehbaren Getriebekammer an der Tragsäule ein ortsfester Motor befestigt ist und drehbare Verschiebeantriebe für die Steuerstangen angeordnet sind, die jeweils eine der Wandungen der Getriebekammer durchdringen und mit jeweils einem zugehörigen Substrathalter in Wirkverbindungen stehen.

Eine solche Anlage dient bevorzugt, aber nicht ausschliesslich für ebene rechteckige bzw. quadratische Substrate in einer zumindest im wesentlichen senkrechten Stellung, enthaltend eine Vakuumkammer mit mindestens zwei auf den Umfang der Vakuumkammer verteilten kammerseitig offenen Behandlungskammern, eine Eintragsschleuse, eine Austragsschleuse und eine drehbare Anordnung von Substrathaltern innerhalb der Vakuumkammer mit einem Antriebsmechanismus für die sequentielle Rotation und den Vorschub und Rückzug der Substrathalter relativ zu den Behandlungskammern.

Kontinuierlich arbeitende Behandlungs- oder Beschichtungsanlagen, die unter Vakuum bis an die Leistungsgrenze der Vakuum-Pumpsätze betrieben werden und in denen unterschiedliche Behandlungen an sogenannten Substraten in einzelnen Behandlungsstationen durchgeführt werden, enthalten in der Regel folgende Baugruppen:
a) mindestens eine Vakuumkammer
b) mindestens ein Evakuierungs- bzw. Pumpensystem,
c) von der Vakuumkammer aus zugängliche Behandlungsstationen mit Behandlungsquellen,
d) ggf. innere Schleusenventile am Eingang der Behandlungsstationen,
e) Versorgungseinrichtungen für die Behandlungsquellen (Strom- und/oder Gasquellen),
f) mindestens ein Schleusensystem mit Schleusenventilen für das Ein- und Ausschleusen der Substrate in die und aus der Vakuumkammer,
g) Transportsysteme für den zwei- oder mehrdimensionalen Transport der Substrate,
h) Substrathalter oder -träger im Zusammenwirken mit den Transportsystemen und
i) ggf. vorgeschaltete Aggregate für die Bereitstellung und/oder den Abstransport der Substrate vor dem Schleusensystem der Anlage.

Soweit es sich um Anlagen mit rotatorischen und ggf. radialen Transportwegen und an mindestens eine, zumindest im wesentlichen rotationssymmetrische, Haupt-Vakuumkammer angeschlossenen Behandlungsstationen oder -kammern handelt, werden solche Anlagen auch als "Cluster-Anlagen" bezeichnet.

Bei den Behandlungsverfahren kommen die Vorwärmung (Ausgasen) und Abkühlung der Substrate, die Vakuum-Aufdampfung, die Katodenzerstäubung, die Plasmabehandlung (z.B. Glimmen zur Reinigung und Haftvermittlung), das PVD-Verfahren, das CVD-Verfahren und das PCVD-Verfahren zur Anwendung, für die zahlreiche Verfahrensparameter und Vorrichtungskomponenten bekannt sind. Hierbei steht "P" für "physical", "C" für "chemical, "V" für "vacuum" und "D" für "deposition". Einige dieser Verfahren, deren Bezeichnungen sich im internationalen Sprachgebrauch durchgesetzt haben, können reaktiv (unter Zufuhr von Reaktionsgasen oder Gasgemischen) oder nicht reaktiv (in Gegenwart von Inertgasen) durchgeführt werden. Hinzu kommen auch Ätzverfahren für die Oberflächenbehandlung einschliesslich der Erzeugung bestimmter "Flächenmuster" und Kontaktlinien auf den Substraten. Sämtliche Verfahrensschritte und Vorrichtungskomponenten kommen auch - je nach den Anforderungen an die Endprodukte - für den Erfindungsgegenstand in Frage.

In der historischen Entwicklung wurden die kontinuierlichen "Cluster-Anlagen" zunächst für relative kleine Substrate wie Disketten, Chips, Datenspeicher und Wafer eingesetzt. Der Weiterentwicklung im Hinblick auf grössere Substrate wie Fensterscheiben und Displays standen jedoch erheblich Probleme im Wege, wie z.B. die Abmessungen der Anlagen, der Platzbedarf für das Handling der Substrate und ggf. der Substrathalter, z.B. das Aufrichten von in horizontaler Lage zugeführten Substraten in eine im wesentlichen senkrechte Stellung, die Gefahr der elastischen Verformung, des Bruchs und/oder der mechanischen Beschädigung der Substrate und/oder deren Beschichtungen und die Verunreinigung, insbesondere durch die Ansammlung von Beschichtungen auf dauernd oder vorübergehend in den Anlagen befindlichen Komponenten und das Abplatzen dieser Verunreinigungen durch unterschiedliche Verfahrensparameter, insbesondere durch Temperaturänderungen oder mechanische Einwirkungen.

So wird z.B. gemäss der weiter unten noch abgehandelten EP 0 136 562 B1 jedes Substrat horizontal liegend einem Schleusensystem zugeführt, darin erst mittels einer Hubvorrichtung nach oben angehoben und dann durch eine Schwenkvorrichtung in eine senkrechte Stellung verschwenkt, in der es an einem Substrathalter befestigt wird. Beim Ausschleusen in einem zweiten Schleusensystem wird dann die Reihenfolge dieser Schritte umgekehrt. Dies würde bei grossflächigen rechteckigen Substraten zu erheblichen Platzproblemen, grossen Schleusen- und Kammervolumina sowie langen Evakuierungszeiten und/oder grossen Saugleistungen der Vakuumpumpen führen.

Durch die EP 0 136 562 B1 ist eine kontinuierliche Katodenzerstäubungsanlage für kleine kreisscheibenförmige Substrate wie Disketten, Halbleiter und Wafer bekannt. Die Aussenkammer ist auf dem Umfang äquidistant mit einer Schleusenanlage und vier kammerförmigen Behandlungsstationen versehen. Auch solche Anlagen gehören zu den "Cluster-Anlagen".

Zwischen einer Aussen- und einer Innenkammer ist drehbar ein polygonaler Topf angeordnet, an dessen Zarge fünf Substrathalter mittels Blattfedern angeordnet sind, die in Betriebsstellung die Schleusenanlage sowie die Bearbeitungskammern mittels Dichtungen und einer Ventilfunktion verschliessen. Die Radialbewegungen der Substrathalter, die ständig in der Vakuumkammer verbleiben, werden ausschliesslich im Stillstand synchron durch einen zentralen Kegel und fünf Schubstangen erzeugt, die in der Zarge der Innenkammer und durch deren Wand in etwa halber Höhe hindurch geführt sind und sich infolgedessen nicht mitdrehen können. Stationär ist auch der Antrieb mit seinem Kegel.

Der Substrathalter-Topf wird schrittweise durch einen weiteren Antrieb gedreht. Um den Substrathalter-Topf innerhalb der Vakuumkammer von Station zu Station drehen zu können, müssen die besagten Schubstangen aus der kreisförmigen bzw. zylindrischen Bewegungsbahn des Substrathalter-Topfes zyklisch zurück gezogen und wieder vorgeschoben werden. über eine Harmonisierung und Anpassung der tangentialen und radialen Geschwindigkeitsverläufe durch den Antriebmechanismus ist - schon wegen der Kleinheit der Substrate - nichts ausgesagt oder angedeutet.

Durch die laufende Vergrösserung der Substratabmessungen und die Verringerung der Formsteifigkeit und -festigkeit durch Verringerung der Substratdicke mit Fortschreiten der Entwicklung sind neue Probleme entstanden, die zu sehr komplexen und aufwändigen Bauprinzipien und komplizierten Betriebsabläufen geführt haben.

Der Erfindung liegt daher die Aufgabe zugrunde, einen Antriebsmechanismus der eingangs angegebenen Art dahingehend zu verbessern, dass auch grossflächige, leicht schräg zur Senkrechten stehende und nicht an den Substrathaltern befestigte Substrate zuverlässig und zumindest weitgehend ruckfrei durch eine Vakuum-Behandlungsanlage hindurch geführt und behandelt werden können.

Im Zuge weiterer Ausgestaltungen der Erfindung sollen auch Bauprinzipien und Betriebsabläufe berücksichtigt werden, die zu einer weiteren Verringerung der Stellfläche, der Kammervolumina, der Evakuierungszeiten und zu einer weiteren Vereinfachung des "Handlings" der Substrate ausserhalb und innerhalb der Vakuumkammer und trotzdem insbesondere zu einer deutlichen Verringerung der Verunreinigungsgefahr der Substrate durch Partikel abgeplatzter Schichtpakete führen.

Die Lösung der gestellten Aufgabe erfolgt bei dem eingangs beschriebenen Antriebsmechanismus erfindungsgemäss durch die Merkmale im Kennzeichen des Patentanspruchs 1, nämlich dadurch, dass
a) der Motor mit einem ortsfesten Lagergehäuse verbunden ist, in dem konzentrisch zur Tragsäule eine drehbare sternförmige Anordnung von Auslegern gelagert ist,
b) die Ausleger gelenkig mit einem Ende doppelarmiger Winkelhebel verbunden sind, die mindestens je einen Gelenkzapfen aufweisen,
c) das jeweils andere Ende der Winkelhebel gelenkig mit jeweils einer der Steuerstangen verbunden ist, und dass
d) die Gelenkzapfen der Winkelhebel in einer ersten ortsfesten Steuerkurve geführt sind, deren Verlauf die Radialbewegungen der Steuerstangen bestimmt.

Durch diese Lösung wird die gestellte Aufgabe in vollem Umfange zufriedenstellend gelöst, und insbesondere werden Bauprinzipien des Antriebsmechanismus angegeben, die zu harmonischen und ruckfreien Bewegungen der Substrathalter auf ihren auf dem Umfang geschlossenen Bewegungsbahnen führen.

Es ist im Zuge weiterer Ausgestaltungen der Erfindung besonders vorteilhaft, wenn - entweder einzeln oder in Kombination:
* die Steuerstangen in Radialführungen gelagert sind, die an der drehbaren Getriebekammer befestigt sind,
* die erste Steuerkurve in einer ortsfesten Steuerplatte unterhalb der Winkelhebel angeordnet ist,
* die Winkelhebel sichelförmig und radial nach aussen gekrümmt ausgebildet und angeordnet sind und dass ihre durch die erste Steuerkurve geführten Gelenkzapfen im mittleren Bereich der Winkelhebel angeordnet sind,
* die den Auslegern abgekehrten Enden der Winkelhebel über Pleuelstangen mit den Steuerstangen verbunden sind,
* die erste Steuerkurve in Umfangsrichtung einen geschlossenen periodisch wellenförmigen Verlauf hat, durch deren maximalen radialen Abstand von der Achse die Endstellung der Substrathalter gegenüber der jeweiligen Behandlungskammer bestimmbar ist,
* innerhalb der ersten ortsfesten Steuerkurve eine zweite ortsfeste Steuerkurve angeordnet ist, dass ferner an der drehbaren sternförmigen Anordnung von Auslegern mindestens ein Schwenkgelenk angeordnet ist, an dem jeweils ein Winkelhebel angeordnet ist, dessen eines Ende durch die zweite Steuerkurve geführt ist und dessen anderes Ende mittels einer Gelenklasche mit der Getriebekammer verbunden ist, derart, dass deren Umfangsgeschwindigkeit in überlagerung zur Radialverschiebung der Substrathalter periodisch variierbar ist,
* an diametral gegenüberliegenden Stellen der sternförmigen Anordnung von Auslegern je ein Schwenkgelenk mit je einem Winkelhebel angeordnet ist, der über je eine Gelenklasche mit der Getriebekammer verbunden ist,
* das dem mindestens Winkelhebel abgekehrte Ende der jeweiligen Gelenklasche über einen Gelenkzapfen mit der Getriebekammer verbunden ist,
* der jeweilige Gelenkzapfen über je ein Winkelstück und ein Gegenstück mit jeweils einer benachbarten Ecke der Getriebekammer verbunden ist,
* an jedem der drehbaren Ausleger mindestens je ein Stellungsmelder angeordnet ist, der mit entsprechenden ortsfesten Stellungsempfängern in Wirkverbindung steht,
* durch Signale der Stellungsmelder und der Stellungsempfänger sowohl die Winkelstellung aller Ausleger als auch die Zuordnung zu einer der Behandlungskammern als auch zu der übergabekammer bestimmbar sind,
* auf dem Umfang der Achse in äquidistanter Winkelverteilung vier Ausleger, eine übergabekammer und drei Behandlungskammern angeordnet sind.
* der Antriebsmechanismus mit der Getriebekammer zwischen dem Boden eines inneren Kammerteils und dem Boden eines äusseren Kammerteils angeordnet ist,
* an der Getriebekammer in kreuzweiser Anordnung vier Paare von waagrechten Auslegern befestigt sind, an denen Parallelogramm-Lenkeranordnungen aufgehängt sind, deren untere Enden über weitere waagrechte Ausleger mit den Substrathaltern verbunden sind,
* die Substrathalter nach oben hin unter Winkeln von 3 bis 15 Grad in Richtung auf die Achse ausgerichtet sind, und/oder, wenn
* in tangentialer Richtung zur Achse an dem Kammerteil eine waagrechte lineare Schleusenreihe angeordnet ist, die aus der Einschleuskammer, der übergabekammer und der Ausschleuskammer besteht, durch die die Substrate unter einem Winkel von 3 bis 15 Grad hindurch führbar sind.

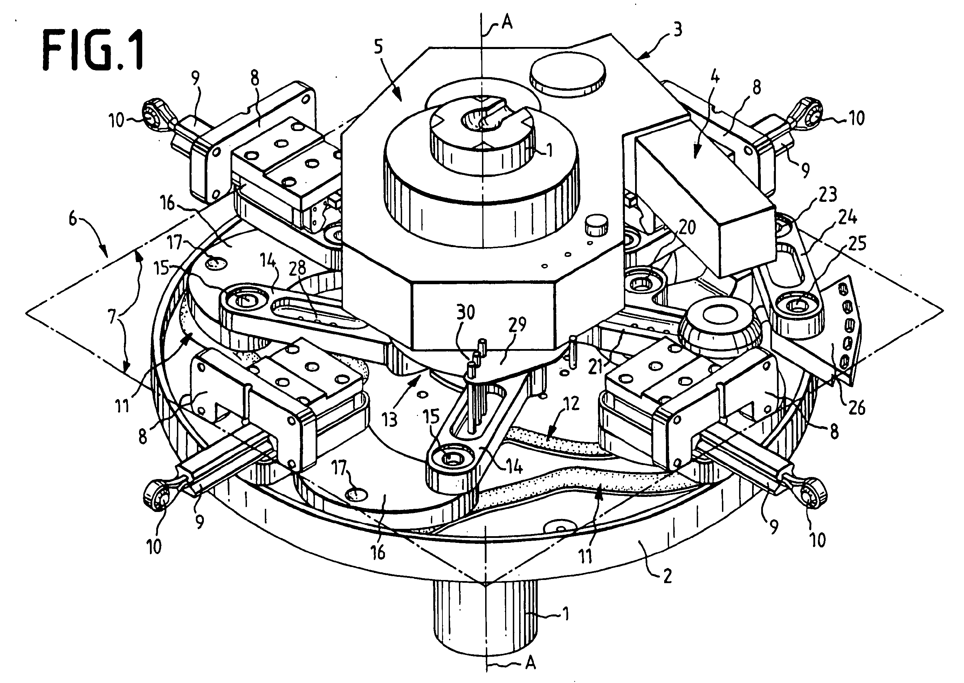

Ein Ausführungsbeispiel des Erfindungsgegenstandes und seine Wirkungsweisen und Vorteile werden nachfolgend anhand der Figuren 1 bis 7 näher erläutert. Es wird betont, dass die Erfindung nicht auf ein Vier-Kammer-Prinzip mit einer übergabekammer und drei Behandlungskammern beschränkt ist und dass die Gesamtzahl der Kammern einschliesslich der Schleusenkammern und des Antriebmechnismmus mit seinen Winkelstellungen - je nach der Produkt-Spezifikation - nach oben und unten verändert werden kann.

Es zeigen:
- Figur 1: eine perspektivische Darstellung des inneren Antriebsmechanismus ohne Gehäuse der Getriebekammer und ohne Substratträger,
- Figur 2: eine senkrechte Draufsicht auf die ortsfeste Steuerplatte mit ihren beiden Steuerkurven,
- Figur 3: eine senkrechte Draufsicht auf den Antriebsmechanismus nach Abnahme von Antriebseinheit mit Motor und Lagergehäuse,
- Figur 4: eine senkrechte Draufsicht analog Figur 3 in einer um 90 Grad gedrehten Stellung der Getriebekammer,
- Figur 5: eine schematische Darstellung der überlagerten Bewegungsabläufe innerhalb einer Vakuumanlage in Umfangsrichtung und in radialen Richtungen,
- Figur 6: eine teilweise axial geschnittene Seitenansicht des Kerns einer Vakuumanlage nach Figur 5 mit der Getriebekammer und zwei daran aufgehängten und ausgefahrenen Substrathaltern und
- Figur 7: eine perspektivische Aussenansicht einer vollständigen Anlage für die Verwendung von Mitteln nach den Figuren 1 bis 6.

In Figur 1 ist eine drehfeste Tragsäule 1 mit einer Achse A-A dargestellt, um die ein weiter unten beschriebenes System von vier Substrathaltern drehbar ist. An dieser Tragsäule sind 1, gleichfalls drehfest, eine scheibenförmige Steuerplatte 2 und - mit Abstand darüber - eine Antriebseinheit 3 mit einem Motor 4 und einem Lagergehäuse 5 befestigt. In dem Zwischenraum zwischen der Steuerplatte 2 und dem Lagergehäuse 5 befindet sich ein komplexes System von Steuerelementen, das nachstehend noch näher beschrieben wird und das in seiner Gesamtheit um die Achse A-A drehbar ist.

Die gesamte Anordnung von Steuerelementen und Antriebseinheit 3 ist von einer um die Achse A-A drehbaren, hier nicht im Detail gezeigten Getriebekammer 6 mit quadratischem Grundriss umgeben, deren innerste Umlaufkante durch eine gestrichelte Linie 7 angedeutet ist. An den vier Seitenwänden der drehbaren Getriebekammer 6 sind innen in äquidistanter Winkelverteilung vier Radialführungen 8 mit je einer radial zur Achse A-A beweglichen Steuerstange 9 befestigt, die an ihren äußeren Enden Schwenklager 10 für die Steuerung von weiter unten noch näher beschriebenen Substrathaltern tragen.

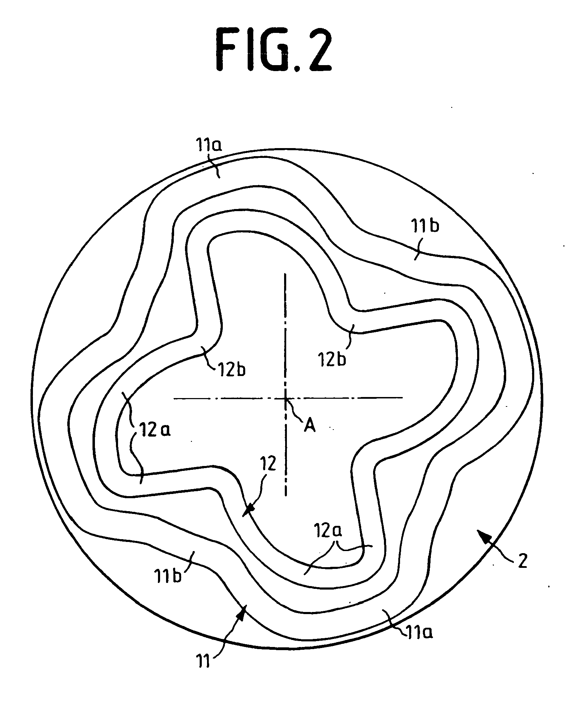

Die Steuerplatte 2 trägt - hier nur ausschnittsweise angedeutet - zwei eingefräste auf dem Umfang geschlossene Steuerkurven, nämlich eine erste, äußere Steuerkurve 11 und eine zweite, innere Steuerkurve 12, deren räumliche Verläufe, auch relativ zueinander, in Figur 2 komplett dargestellt sind.

Unmittelbar unterhalb des ortfesten Lagergehäuses 5 ist in diesem ein drehbares Drehkreuz 13 mit vier auf dem Umfang äquidistant angeordneten Auslegern 14 gelagert, von deren in Figur 1 nur zwei sichtbar sind. Diese greifen mit ihren äusseren Enden mittels Drehlagern 15 in die einen Enden von vier Winkelhebeln 16 ein, deren andere, hier nicht sichtbare Enden mit den Steuerstangen 9 in Wirkverbindung stehen, was weiter unten noch näher beschrieben wird.

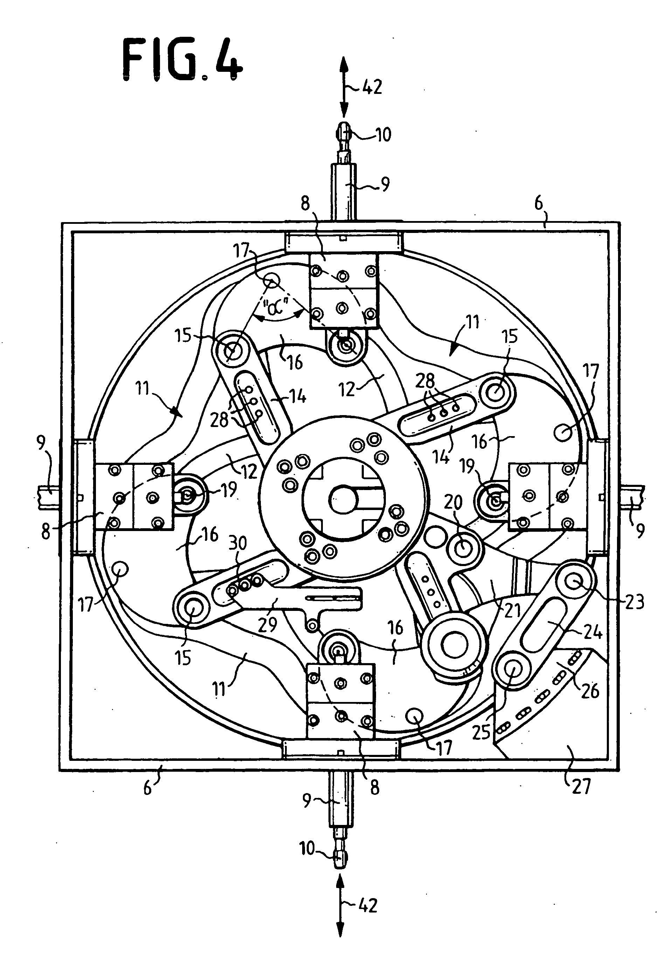

In ihren mittleren Bereichen greifen die Winkelhebel 16 über Gelenkzapfen 17 und unterhalb der Winkelhebel 16 angeordneten Führungsrollen in die äußere Steuerkurve 11 ein. Die Winkelhebel 16 sind hier sichelförmig dargestellt. Massgeblich ist jedoch die Winkelstellung von jeweils zwei virtuellen geraden Linien, die von dem jeweiligen Drehlager 15 zum Gelenkzapfen 17 einerseits und von diesem zur gelenkigen Verbindungsstelle mit der zugehörigen Steuerstange andererseits verlaufen. Der Winkel "α" mit dem Scheitel in der Achse des Gelenkzapfens 17 kann zwischen 60 und 120 Grad liegen (siehe hierzu die Figur 4, oben).

Bereits aus Figur 2 wird deutlich, dass durch die graduellen übergänge zwischen den relativ äußeren Kurvenabschnitten 11a und den relativ inneren Kurvenabschnitten 11 b ruckfreie Radialbewegungen der Steuerstangen 9 ermöglicht werden.

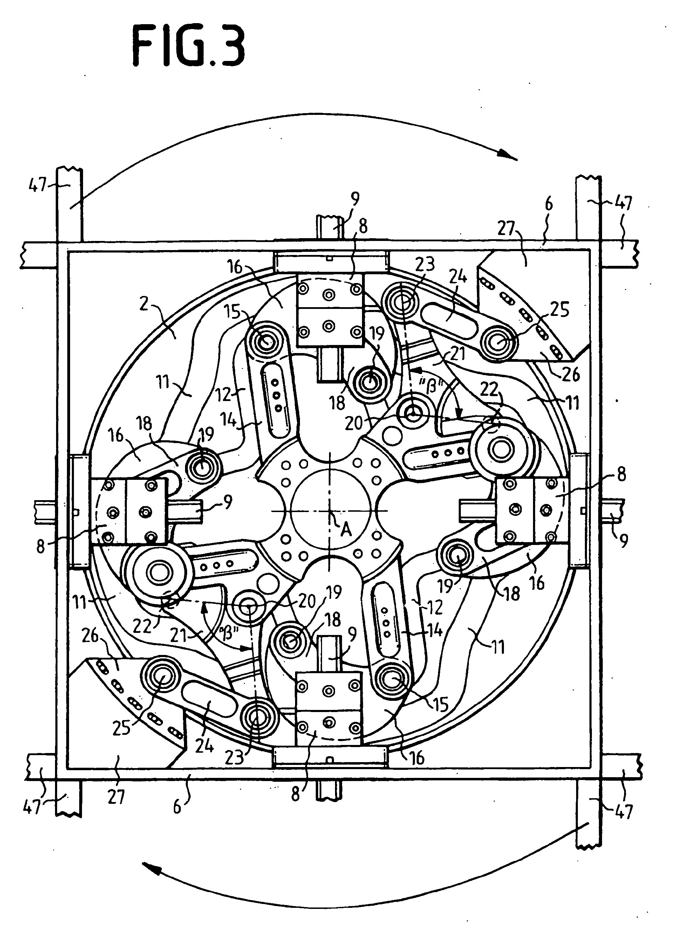

Aus Figur 3, bei der ein Teil der Steuerelemente weggelassen ist, geht zusätzlich hervor, dass die Winkelhebel 16 an den den Auslegern 14 abgekehrten Enden über je eine Pleuelstange 18 und ein erstes Gelenk 19 mit den Steuerstangen 9 verbunden sind. Das jeweils zweite Gelenk ist durch die Deckplatten der Radialführungen 8 verdeckt, die zu diesem Zweck nach unten hin offen sind, wie dies aus Figur 1 hervorgeht.

Nachdem nunmehr die Steuerung der Radialbewegungen durch die rotative Relativbewegung zwischen der äußeren ortsfesten Steuerkurve 11 der Steuerplatte 2 und den umlaufenden Steuerstangen 9 erläutert wurde, geht es um die Beschreibung der Steuerung der überlagerten periodisch variablen Umlaufgeschwindigkeit der Steuerstangen 9 durch die rotative Relativbewegung zwischen der inneren ortsfesten Steuerkurve 12 der Steuerplatte 2 und den umlaufenden Steuerstangen 9:

Wie gleichfalls aus Figur 3 hervorgeht, sind am Drehkreuz 13 mit den starr daran angebrachten Auslegern 14 diametral gegenüber liegend zwei Schwenkgelenke 20 angebracht, um die je ein weiterer Winkelhebel 21 begrenzt schwenkbar ist. Die Winkelhebel 21 besitzen jeweils zwei Gelenkzapfen 22 und 23, von denen die ersten teilweise verdeckt und mittels einer nicht gezeigten (verdeckten) Rolle in der inneren Steuerkurve 12 geführt sind. Die Winkelstellungen der Gelenkzapfen 22 und 23 relativ zum Schwenkgelenk 20 haben den Winkel "β", was in Figur 3, rechts oben und links unten, dargestellt ist. Dieser Winkel kann je nach den Platzverhältnissen und der Bewegungskinematik zwischen 60 und 120 Grad gewählt werden. Durch die diametrale Anordnung von zwei Winkelhebeln 21 werden unvermeidbar auftretende Radialkräfte kompensiert, jedoch ist es grundsätzlich möglich, nur mit jeweils einem der Winkelhebel 21 auszukommen.

Aus Figur 2 wird zusätzlich deutlich, dass durch die graduellen bzw. harmonischen übergänge zwischen den relativ äußeren Kurvenabschnitten 12a und den relativ inneren Kurvenabschnitten 12b ruckfreie Radialbewegungen der Gelenkzapfen 22 ermöglicht werden. Diesen Radialbewegungen folgt - nach Massgabe der Hebellängen und der Winkelstellung der Gelenkzapfen 22 und 23 relativ zum Schwenkgelenk 20 die Umfangsgeschwindigkeit der Getriebekammer 6 in Richtung der beiden äußeren Pfeile.

Die Gelenkzapfen 23 sind durch je eine Gelenklasche 24 und je einen weiteren Gelenkzapfen 25 mit je einem Winkelstück 26 verbunden, das begrenzt verstellbar an je einem Gegenstück 27 befestigt ist, die in zwei diametral gegenüber liegenden Ecken mit der Getriebekammer 6 verbunden sind. Hierdurch wird die Umlaufgeschwindigkeit der Getriebekammer 6 nach Massgabe des Verlaufs der inneren Steuerkurve 12 graduell und periodisch zwischen Maximalwerten und Stillstand variiert. Der Stillstand erfolgt dann, wenn sich die Steuerstangen 9 entweder genau vor der übernahmekammer für die Substrate oder genau vor jeweils einer der Behandlungskammern befinden.

Figur 4 zeigt - unter Fortschreibung der Bezugszeichen - Komponenten des Steuerantriebs nach Demontage der Antriebseinheit 3 mit dem Motor 4 und dem Lagergehäuse 5. Es ist ersichtlich, dass der Steuerantrieb die Getriebekammer 6 um einen Winkel von 90 Grad im Uhrzeigersinne fortgeschaltet hat, erkennbar an der Lage des Gelenkzapfens 25, des Winkelstücks 26 und des Gegenstücks 27 in der Ecke rechts unten. Dieser Bewegung sind das Drehkreuz 13, das Schwenkgelenk 20, der Winkelhebel 21 und alle Radialführungen 8 mit den Steuerstangen 9 gefolgt. Der übersichtlichkeit halber ist einer der Winkelhebel 21 in Figur 3 mit seinen Anschlusselementen weggelassen, die dann links oben liegen müssten.

Die Figuren 1 und 4 zeigen noch folgendes: An den Auslegern 14 sind jeweils drei Stellungsmelder 28 angeordnet, und an dem Lagergehäuse 5, das hier nicht dargestellt ist, sind damit in einer koaxialen komplementären Deckungsmöglichkeit an einem Ausleger 29 drei Stellungsempfänger 30 befestigt, mit denen es folgende Bewandtnis hat: Durch entsprechende Datenübertragung und -auswertung ist es möglich, nicht nur die jeweilige Stellung der Ausleger 14 und der Steuerstangen 9 gegenüber den Behandlungskammern und der übergabekammer innerhalb der Schleusenreihe zu bestimmen, sondern auch, welche Steuerstange 9 welcher Kammer gegenüber liegt.

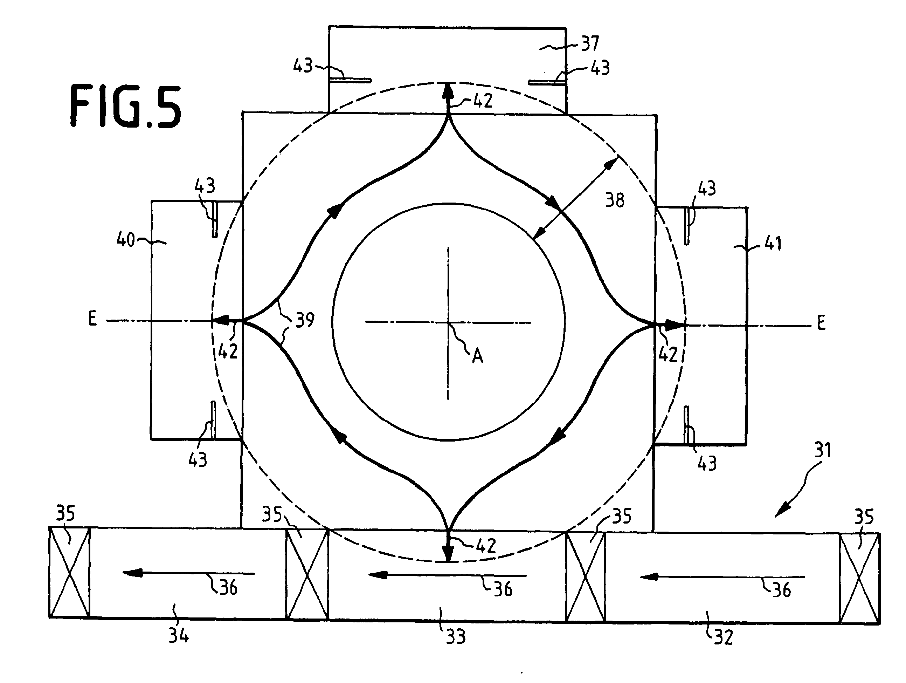

Die Figur 5 zeigt nun eine schematische Darstellung der überlagerten Bewegungsabläufe in Umfangsrichtung und in radialer Richtung. Parallel zur Schnittlinie E-E verläuft eine Schleusenreihe 31, die aus einer Eintragsschleuse 32 einer übergabekammer 33 und einer Austragsschleuse 34 besteht. Die Schleusenreihe 31 enthält Vakuumventile 35 bekannter Bauart.

Die lineare schrittweise Transportrichtung der schräg stehenden bzw. geführten Substrate ohne Substrathalter durch die Schleusenreihe 31 ist durch die Reihe der Pfeile 36 angedeutet. Der übergabekammer 33 liegt eine Behandlungskammer 37 gegenüber. Im Innern eines ringförmigen Raumes 38 sind die harmonischen bzw. graduellen Bewegungsfolgen durch dicke Pfeillinen angedeutet. Die Drehbewegung erfolgt - von der übergabekammer 33 ausgehend - um jeweils 90 Grad entlang der geschlossenen Pfeillinie 39. An den vier Haltepunkten jeweils unmittelbar vor der übergabekammer 33 und den Behandlungskammern 40, 37 und 41 sind durch radiale Pfeile 42 Vorschub und Rückzug der Substrate angedeutet. Der Vorschub der Substrate erfolgt bis unmittelbar vor abschirmende rahmenförmige Blenden 43, die in den öffnungsbereichen der Behandlungskammern 40, 37 und 41 angeordnet sind. Eine abdichtende Wirkung zwischen den Substraten und diesen Blenden 40 ist jedoch nicht erforderlich, schon weil die äußerst dünnen Substrate hierfür keinen Beitrag leisten können oder müssen. Sobald die Rückwärtsbewegungen der Substrathalter vollendet sind, werden diese um 90 Grad vor die jeweils nächste Behandlungskammer gedreht, am Ende der Behandlung vor die übergabekammer 33 zum Weitertransport in die Austragsschleuse 34.

Aus der Figur 5 geht die äußerst kompakte, Raum und Volumen sparende Ausbildung der Anlage hervor, insbesondere die Tatsache, daß die Substrathalter nicht an die Atmosphäre ausgeschleust werden müssen. In allen Fällen sind auch in den Schleusenkammern 32 und 34 perforierte Substrathalter mit Druckgasversorgung über die gesamte Substratfläche und Rollen am unteren Ende angeordnet, so daß die Substrate reibungsfrei über Gaspolstern auf die Substrathalter aufgeschoben und wieder abgeschoben werden können. Zum Evakuieren und beim Stillstand der Substrate auf ihren Haltern werden die Gasversorgungen vorübergehend abgestellt. Dies gilt auch für die Zeitspanne, in der sich die Substrate auf ihren Substrathaltern in dem ringförmigen Raum 38 befinden.

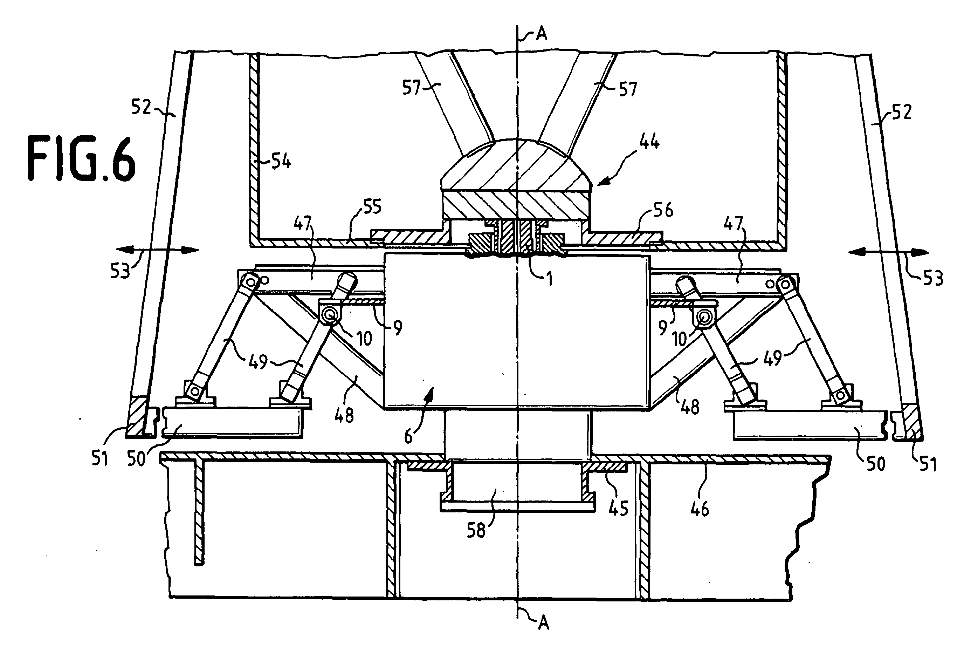

In Figur 6 ist ein zentraler Antriebsmechanismus 44 mit senkrechter Achse A-A, einem koaxialen Montageflansch 45 und der Getriebekammer 6 dargestellt, in der die Anordnung nach den Figuren 1 bis 4 angeordnet ist. Der Montageflansch 45 dient zur Befestigung an einem hier nur teilweise gezeigten unteren Boden 46 der Vakuumkammer. An den Ecken der drehbaren Getriebekammer 6 sind insgesamt acht Ausleger 47 befestigt, die sich über Schrägstreben 48 an der Getriebekammer 6 abstützen (siehe hierzu auch die Figur 3).

An den Auslegern 47, die paarweise parallel zueinander verlaufen und ein rechtwinkliges Kreuz bilden, hängen über obere, Schwenklager insgesamt acht Parallelogramm-Lenkeranordnungen 49 nach unten. Die unteren Enden der Parallelogramm-Lenkeranordnungen 49 sind schwenkbar an waagrechten Auslegern 50 in Form U-förmiger Bügel mit paarweise zueinander parallelen Schenkeln gelagert, deren nach außen gerichtete Enden durch je eine waagrechte Traverse 51 eines rahmenförmigen Substrathalters 52 verbunden sind, die für hier nicht gezeigte Substrate dienen. Nach oben hin sind die Substrathalter 52 schräg nach hinten unter einem Winkel zwischen 3 und 15 Grad zur Senkrechten ausgerichtet.

Die beiden gezeigten Substrathalter 52 sind dadurch in Richtung der Pfeile 53 entgegengesetzt und im wesentlichen radial zueinander bewegbar. Es ist zu betonen, daß nur zwei der Substrathalter 52 gezeigt sind. Die beiden anderen Substrathalter, die vor und hinter der Getriebekammer 6 angeordnet sind, sind der übersichtlichkeit halber nicht dargestellt. Sie sind gleichfalls in entgegengesetzten Richtungen radial beweglich, und zwar im rechten Winkel zu den beiden Pfeilen 53.

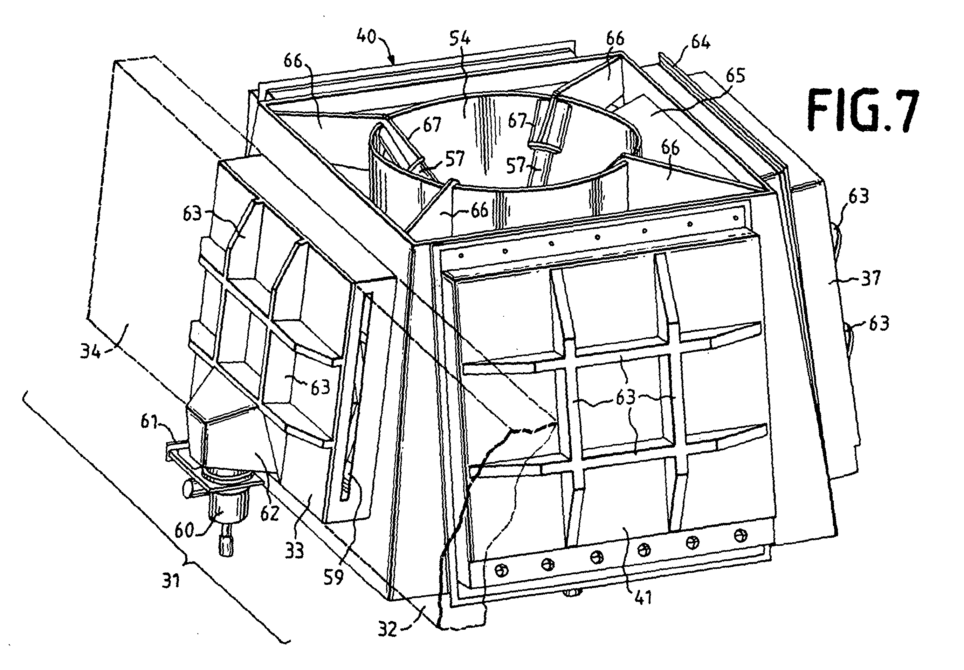

Die Getriebekammer 6 ist in eine Vakuumkammer mit der vertikalen Achse A-A integriert. Diese Vakuumkammer besteht aus einem inneren, topfförmigen Kammerteil 54 mit einem Boden 55, in den der obere Endbereich der Tragsäule 1 mittels eines Flansches 56 vakuumdicht und drehfest eingesetzt ist. Die vertikale Abstützung erfolgt über Ankerstreben 57, deren wirksame Länge über in Figur 7 gezeigte Einstellelemente 67 veränderbar ist. Hiervon sind nur die beiden hinter der vertikalen Schnittebene (E-E in Figur 5) liegenden Ankerstreben 57 gezeigt, die gemäss Figur 7 an radialen Knotenblechen 66 aufgehängt sind.

Die Vakuumkammer besitzt weiterhin einen äußeren Kammerteil 64 (siehe Figur 7) in Form eines vierkantigen Pyramidenstumpfes mit dem Boden 46, durch den ein unterer Fortsatz 58 der Getriebekammer 6 vakuumdicht, aber drehbar hindurchgeführt ist.

Zwischen den waagrechten Böden 46 und 55 befinden sich die wesentlichen drehbaren Teile des Antriebsmechanismus 44. In den ringförmigen Raum 38 (siehe die Figur 5) ragen von unten nach oben die drehbaren und mit radialen Bewegungskomponenten verschiebbaren Substrathalter 52. Schiebedurchführungen durch die zylindrische Wand des inneren Kammerteils 54 sind nicht vorhanden. Die Verlagerungen der Substrathalter 52 erfolgen vielmehr durch die bereits beschriebenen Parallelogramm-Lenkeranordnungen 49, bei denen sich die Raumlage der Schwenklager bereits aus der Definition "Parallelogramm-Lenkeranordnungen" ergibt. Es erfolgt also eine symmetrische Verschwenkung um eine Mittellage. Durch eine ausreichende Bemessung der Länge der Lenker bei vorgegebener Bemessung des Schwenkwinkels bzw. der radialen Bewegungskomponente läßt sich erreichen, dass die vertikale Bewegungskomponente kleinstmöglich wird.

Solche Schwenklager erzeugen im Gegensatz zu Schiebe-Durchführungen praktisch keinen Abrieb und auch keinen Staub von Beschichtungsmaterial, der die Schichtqualitäten auf den Substraten beeinflussen könnte. Hinzu kommt, daß der Angriff der Ausleger 50 an den Substrathaltern 52 an deren Unterkanten erfolgt und nicht in Substratmitte wie bei dem Gegenstand der EP 0 136 562 B1. Die unteren Schwenklager der bereits beschriebenen Parallelogramm-Lenkeranordnungen 49 liegen nur mit geringstmöglichem Abstand über den Oberseiten der Ausleger 50 und auf den Rückseiten der Substrathalter 52, so daß etwaiger Abrieb auch aus diesem Grund die Außenseiten der Substrate nicht erreichen kann.

Aus Figur 6 geht weiterhin hervor, dass die äußeren Enden der waagrechten Steuerstangen 9 für die zyklischen Bewegungen der bereits beschriebenen Parallelogramm-Lenkeranordnungen 49 aus der Getriebekammer 6 herausragen und an den jeweils inneren Lenkern über die Schwenklager 10 angreifen.

Die Figur 7 zeigt nun - unter Fortschreibung der bisherigen Bezugszeichen - eine perspektivische Außenansicht einer vollständigen Anlage für die Verwendung von Mitteln nach den Figuren 1 bis 6. Beiderseits der übergabekammer 33 sind die Eintragsschleuse 32 und die Austragsschleuse 34 gestrichelt angedeutet. Von der übergabekammer 33 ist der schräg stehende Eintrittsschlitz 59 gezeigt, desgleichen ein daran angeschlossener Pumpstutzen 60 mit einem Absperrschieber 61 und einer Kryopumpe 62. Deutlich sichtbar sind die Verrippungen 63 der der übergabekammer 33 und der Behandlungskammer 41 gegen den Atmosphärendruck. Zwischen dem inneren Kammerteil 54 und dem äusseren Kammerteil 64 ist eine ringförmige bzw. auf dem Umfang geschlossene Decke 65 angeordnet, über der sich Knotenbleche 66 befinden, die zu Einstell-Elementen 67 für die Justierung der Ankerstreben 57 innerhalb des Kammerteils 54 führen.

Speziell aus den Figuren 5 bis 7 geht die äußerst kompakte, Raum und Volumen sparende Ausbildung der Anlage hervor, insbesondere die Tatsache, daß die Substrathalter nicht an die Atmosphäre ausgeschleust werden müssen.

### Bezugszeichenliste:

- 1: Tragsäule
- 2: Steuerplatte
- 3: Antriebseinheit
- 4: Motor
- 5: Lagergehäuse
- 6: Getriebekammer
- 7: Linie
- 8: Radialführungen
- 9: Steuerstangen
- 10: Schwenklager
- 11: Steuerkurve
- 11a: Kurvenabschnitte
- 11 b: Kurvenabschnitte
- 12: Steuerkurve
- 12a: Kurvenabschnitte
- 12b: Kurvenabschnitte
- 13: Drehkreuz
- 14: Ausleger
- 15: Drehlager
- 16: Winkelhebel
- 17: Gelenkzapfen
- 18: Pleuelstangen
- 19: Gelenke
- 20: Schwenkgelenk
- 21: Winkelhebel
- 22: Gelenkzapfen
- 23: Gelenkzapfen
- 24: Gelenklasche
- 25: Gelenkzapfen
- 26: Winkelstück
- 27: Gegenstück
- 28: Stellungsmelder
- 29: Ausleger
- 30: Stellungsempfänger
- 31: Schleusenreihe
- 32: Eintragsschleuse
- 33: übergabekammer
- 34: Austragsschleuse
- 35: Vakuumventile
- 36: Pfeile
- 37: Behandlungskammer
- 38: Raum
- 39: Pfeillinie
- 40: Behandlungskammer
- 41: Behandlungskammer
- 42: Pfeile
- 43: Blenden
- 44: Antriebsmechanismus
- 45: Montageflansch
- 46: Boden
- 47: Ausleger
- 48: Schrägstreben
- 49: Parallelogramm-Lenkeranordnungen
- 50: Ausleger
- 51: Traverse
- 52: Substrathalter
- 53: Pfeile
- 54: Kammerteil
- 55: Boden
- 56: Flansch
- 57: Ankerstreben
- 58: Fortsatz
- 59: Eintrittsschlitz
- 60: Pumpstutzen
- 61: Absperrschieber
- 62: Kryopumpe
- 63: Verrippungen
- 64: Kammerteil
- 65: Decke
- 66: Knotenbleche
- 67: Einstell-Elemente

- A-A: Achse
- α: Winkel
- β: Winkel
- E-E: Schnittlinie/Ebene

## Patentansprüche

1. Antriebsmechanismus für eine Vakuum-Behandlungsanlage, durch die mehrere Substrathalter (52) auf einer Umlaufbahn um eine Achse (A-A) von einer Eintragsschleuse (32) über mindestens eine Behandlungskammer (37, 40, 41) zu einer Austragsschleuse (34) transportierbar sind, wobei im Zentrum der Umlaufbahn eine ortsfeste Tragsäule (1) angeordnet ist, auf der eine drehbare Getriebekammer (6) gelagert ist, auf deren Aussenseiten Steuerstangen (9) für eine Rotation und eine Radialverlagerung der Substrathalter (52) angeordnet sind, wobei in der drehbaren Getriebekammer (6) an der Tragsäule (1) ein ortsfester Motor (4) befestigt ist und drehbare Verschiebeantriebe für die Steuerstangen (9) angeordnet sind, die jeweils eine der Wandungen der Getriebekammer (6) durchdringen und mit jeweils einem zugehörigen Substrathalter (52) in Wirkverbindungen stehen, **dadurch gekennzeichnet, dass**
a) der Motor (4) mit einem ortsfesten Lagergehäuse (5) verbunden ist, in dem konzentrisch zur Tragsäule (1) eine drehbare sternförmige Anordnung von Auslegern (14) gelagert ist,
b) die Ausleger (14) gelenkig mit einem Ende doppelarmiger Winkelhebel (16) verbunden sind, die mindestens je einen Gelenkzapfen (17) aufweisen,
c) das jeweils andere Ende der Winkelhebel (16) gelenkig mit jeweils einer der Steuerstangen (9) verbunden ist, und dass
d) die Gelenkzapfen (17) der Winkelhebel (16) in einer ersten ortsfesten Steuerkurve (11) geführt sind, deren Verlauf die Radialbewegungen der Steuerstangen (9) bestimmt.

2. Antriebsmechanismus nach Anspruch 1, **dadurch gekennzeichnet, dass** die Steuerstangen (9) in Radialführungen (8) gelagert sind, die an der drehbaren Getriebekammer (6) befestigt sind.

3. Antriebsmechanismus nach Anspruch 1, **dadurch gekennzeichnet, dass** die erste Steuerkurve (11) in einer ortsfesten Steuerplatte (2) unterhalb der Winkelhebel (16) angeordnet ist.

4. Antriebsmechanismus nach Anspruch 1, **dadurch gekennzeichnet, dass** die Winkelhebel (16) sichelförmig und radial nach aussen gekrümmt ausgebildet und angeordnet sind und dass ihre durch die erste Steuerkurve (11) geführten Gelenkzapfen (17) im mittleren Bereich der Winkelhebel (16) angeordnet sind.

5. Antriebsmechanismus nach Anspruch 1, **dadurch gekennzeichnet, dass** die den Auslegern (14) abgekehrten Enden der Winkelhebel (16) über Pleuelstangen (18) mit den Steuerstangen (9) verbunden sind.

6. Antriebsmechanismus nach Anspruch 1, **dadurch gekennzeichnet, dass** die erste Steuerkurve (11) in Umfangsrichtung einen geschlossenen periodisch wellenförmigen Verlauf hat, durch deren maximalen radialen Abstand von der Achse (A-A) die Endstellung der Substrathalter (52) gegenüber der jeweiligen Behandlungskammer (37, 40, 41) bestimmbar ist.

7. Antriebsmechanismus nach Anspruch 1, **dadurch gekennzeichnet, dass** innerhalb der ersten ortsfesten Steuerkurve (11) eine zweite ortsfeste Steuerkurve (12) angeordnet ist, dass ferner an der drehbaren sternförmigen Anordnung von Auslegern (14) mindestens ein Schwenkgelenk (20) angeordnet ist, an dem jeweils ein Winkelhebel (21) angeordnet ist, dessen eines Ende durch die zweite Steuerkurve (12) geführt ist und dessen anderes Ende mittels einer Gelenklasche (24) mit der Getriebekammer (6) verbunden ist, derart, dass deren Umfangsgeschwindigkeit in überlagerung zur Radialverschiebung der Substrathalter (52) periodisch variierbar ist.

8. Antriebsmechanismus nach Anspruch 7, **dadurch gekennzeichnet, dass** an diametral gegenüberliegenden Stellen der sternförmigen Anordnung von Auslegern (14) je ein Schwenkgelenk (20) mit je einem Winkelhebel (21) angeordnet ist, der über je eine Gelenklasche (24) mit der Getriebekammer (6) verbunden ist.

9. Antriebsmechanismus nach Anspruch 7, **dadurch gekennzeichnet, dass** das dem mindestens einen Winkelhebel (21) abgekehrte Ende der jeweiligen Gelenklasche (24) über einen Gelenkzapfen (25) mit der Getriebekammer (6) verbunden ist.

10. Antriebsmechanismus nach Anspruch 9, **dadurch gekennzeichnet, dass** der jeweilige Gelenkzapfen (25) über je ein Winkelstück (26) und ein Gegenstück (27) mit jeweils einer benachbarten Ecke der Getriebekammer (6) verbunden ist.

11. Antriebsmechanismus nach Anspruch 1, **dadurch gekennzeichnet, dass** an jedem der drehbaren Ausleger (14) mindestens je ein Stellungsmelder (28) angeordnet ist, der mit entsprechenden ortsfesten Stellungsempfängern (30) in Wirkverbindung steht.

12. Antriebsmechanismus nach Anspruch 11, **dadurch gekennzeichnet, dass** durch Signale der Stellungsmelder (28) und der Stellungsempfänger (30) sowohl die Winkelstellung aller Ausleger (14) als auch die Zuordnung zu einer der Behandlungskammern (37, 40, 41) als auch zu der übergabekammer (33) bestimmbar sind.

13. Antriebsmechanismus nach Anspruch 1, **dadurch gekennzeichnet, dass** auf dem Umfang der Achse (A-A) in äquidistanter Winkelverteilung vier Ausleger (14), eine übergabekammer (33) und drei Behandlungskammern (37, 40, 41) angeordnet sind.

14. Antriebsmechanismus nach Anspruch 1, **dadurch gekennzeichnet, dass** der Antriebsmechanismus (44) mit der Getriebekammer (6) zwischen dem Boden (55) eines inneren Kammerteils (54) und dem Boden (46) eines äußeren Kammerteils (64) angeordnet ist.

15. Antriebsmechanismus nach Anspruch 14, **dadurch gekennzeichnet, dass** an der Getriebekammer (6) in kreuzweiser Anordnung vier Paare von waagrechten Auslegern (47) befestigt sind, an denen Parallelogramm-Lenkeranordnungen (49) aufgehängt sind, deren untere Enden über weitere waagrechte Ausleger (50) mit den Substrathaltern (52) verbunden sind.

16. Antriebsmechanismus nach Anspruch 1, **dadurch gekennzeichnet, dass** die Substrathalter (52) nach oben hin unter Winkeln von 3 bis 15 Grad in Richtung auf die Achse (A-A) ausgerichtet sind.

17. Antriebsmechanismus nach den Ansprüchen 14 und 16, **dadurch gekennzeichnet, dass** in tangentialer Richtung zur Achse (A-A) an dem Kammerteil (64) eine waagrechte lineare Schleusenreihe (31) angeordnet ist, die aus der Einschleuskammer (32), der übergabekammer (33) und der Ausschleuskammer (34) besteht, durch die die Substrate unter einem Winkel von 3 bis 15 Grad hindurch führbar sind.

## Claims

1. Drive mechanism for a vacuum treatment plant, with which several substrate holders (52) can be transported on a circulation path around an axis (A-A) of a intake lock (32) via at least one treatment chamber (37, 40, 41) to an outlet lock (34), whereby a locationally fixed support column (1) is positioned in the centre of the circulation path, on which a rotatable gear chamber (6) is bearingly positioned, on the outsides of which control rods (9) are located for a rotation and a radial offsetting of the substrate holder (52), whereby a locationally fixed motor (4) and rotatable offsetting drives for the control rod (9) is fitted in the rotatable gear chamber (6) on the support column (1), which each penetrate one of the walls of the gear chamber (6) and are each operatively connected with an associated substrate holder (52),
**characterised in that**
a) the motor (4) is connected with a locationally fixed bearing housing (5) in which a rotatable star-shaped arrangement of booms (14) is bearingly positioned concentric in relation to the support column (1),
b) the booms (14) are jointably connected with an end of twin-levered angle levers (16), which each comprise at least one joint spigot (17),
c) the relevant other end of the angle levers (16) is jointably connected with one of the control rods (9), and **in that**
d) the joint spigots (17) of the angle levers (16) are guided in a first locationally fixed control curve (11), the expansion of which determines the radial movements of the control rod (9).

2. Drive mechanism according to Claim 1, **characterised in that** the control rods (9) are bearingly positioned in radial guides (8), which are affixed to the rotatable gear chamber (6).

3. Drive mechanism according to Claim 1, **characterised in that** the first control curve (11) is positioned in a locationally fixed control plate (2) below the angle levers (16).

4. Drive mechanism according to Claim 1, **characterised in that** the angle levers (16) are formed sickle-shaped and extend radially arced towards the outside, and **in that** their joint spigots (17) guided by the first control curve (11) are positioned in a central area of the angle levers (16).

5. Drive mechanism according to Claim 1, **characterised in that** the ends of the angle levers (16) facing away from the booms (14) are connected with the control rods (9) via piston rods (18).

6. Drive mechanism according to Claim 1, **characterised in that** the first control curve (11) has a closed, periodically wave-shaped expansion in circumference direction, the maximum radial distance of which from the axis (A-A) can determine the end position of the substrate holder (52) in relation to the relevant treatment chamber (37, 40, 41).

7. Drive mechanism according to Claim 1, **characterised in that** a second locationally fixed control curve (12) is located within the first locationally fixed control curve (11), also **in that** at least one tilt joint (20) is located on the rotatable star-shaped arrangement of booms (14), on each of which an angle lever (21) is located, one end of which is guided through the second control curve (12), and the other end of which is connected with the gear chamber (6) via a joint tab (24) in such a way that the circumference speed of the same is periodically variable when overlaying for a radial offset of the substrate holder (52).

8. Drive mechanism according to Claim 7, **characterised in that** a tilt joint (20) with an angle lever (21) each is located in diametrically opposed locations of the star-shaped arrangement of booms (14), the same being connected with the gear chamber (6) via a joint tab (24) each.

9. Drive mechanism according to Claim 7, **characterised in that** the end of the relevant joint tab (24) facing away from the at least angle lever (21) is connected with a gear chamber (6) via a joint spigot (25).

10. Drive mechanism according to Claim 9, **characterised in that** each relevant joint spigot (25) is connected with an adjacent corner of the gear chamber (6) via an angle piece (26) and a counter piece (27).

11. Drive mechanism according to Claim 1, **characterised in that** at least one position transmitters (28) is located on each of the rotatable booms (14), the same being connected in a working relationship with corresponding locationally fixed position receivers (30).

12. Drive mechanism according to Claim 11, **characterised in that** the angle position of all booms (14) and the relationship of the same to one of the treatment chambers (37, 40, 41) as well as the transmission chamber (33) can be determined by means of signals from the position transmitter (28) and the position receiver (30).

13. Drive mechanism according to Claim 1, **characterised in that** four booms (14), a transmission chamber (33), and three treatment chambers (37, 40, 41) are located around the circumference of the axis (A-A) in equidistant angle distribution.

14. Drive mechanism according to Claim 1, **characterised in that** the drive mechanism (44) with the gear chamber (6) is located between the floor (55) of an internal chamber section (54) and the floor (46) of an external chamber section (64).

15. Drive mechanism according to Claim 14, **characterised in that** four pairs of vertical booms (47) are affixed to the gear chamber (6) in a cross-wise arrangement, on which parallelogram steering arrangements (49) are suspended, the lower ends of which are connected with the substrate holders (52) via further booms (50).

16. Drive mechanism according to Claim 1, **characterised in that** the substrate holders (52) are aligned in an upward direction towards the axis (A-A) at angles of between 3 and 15 degrees.

17. Drive mechanism according to Claims 14 and 16, **characterised in that** a vertical linear lock series (31) is arranged on the chamber part (64) in a tangential direction in relation to the axis (A-A), consisting of the intake chamber (32), the transmission chamber (33), and the outlet chamber (34), through which the substrate can be guided at an angle of between 3 and 15 degrees.

## Revendications

1. Mécanisme d'entraînement pour une installation de traitement sous vide à travers laquelle peuvent être transportés plusieurs supports de substrats (52), sur une trajectoire de révolution autour d'un axe (A-A), d'un sas d'introduction (32), en passant par au moins une chambre de traitement (37, 40, 41), à un sas de sortie (34), mécanisme d'entraînement dans lequel une colonne de support (1) en position fixe est disposée au centre de la trajectoire de révolution, et sur cette colonne de support est montée rotative une chambre de transmission (6) sur les côté extérieurs de laquelle sont agencées des tiges de commande (9) pour produire une rotation et un déplacement radial des supports de substrats (52), la configuration étant par ailleurs telle que dans la chambre de transmission (6), sur la colonne de support (1), est fixé un moteur (4) en position fixe et sont disposés des entraînements de translation, rotatifs, pour les tiges de commande (9), qui traversent respectivement une des parois de la chambre de transmission (6) et sont respectivement en interaction avec un support de substrat (52) associé,
**caractérisé en ce que**
a) le moteur (4) est relié à un carter de palier (5) en position fixe, dans lequel est monté rotatif, concentriquement à la colonne de support (1), un agencement de bras (14), en forme d'étoile,
b) les bras (14) sont reliés de manière articulée à une extrémité de leviers coudés (16) à bras double, qui présentent chacun au moins un tourillon d'articulation (17),
c) l'autre extrémité respective des leviers coudés (16) est reliée à l'une respective des tiges de commande (9), et **en ce que**
d) les tourillons d'articulation (17) des leviers coudés (16) sont guidés dans un premier chemin de came de commande (11) en position fixe, dont le tracé détermine les mouvements radiaux des tiges de commande (9).

2. Mécanisme d'entraînement selon la revendication 1, **caractérisé en ce que** les tiges de commande (9) sont montées dans des guidages radiaux (8) qui sont fixés sur la chambre de transmission (6) rotative.

3. Mécanisme d'entraînement selon la revendication 1, **caractérisé en ce que** le premier chemin de came de commande (11) est agencé dans une plaque de commande (2) en position fixe sous les leviers coudés (16).

4. Mécanisme d'entraînement selon la revendication 1, **caractérisé en ce que** les leviers coudés (16) sont réalisés en forme de faucille et agencés en étant coudés vers l'extérieur, et **en ce que** leurs tourillons d'articulation (17) guidés par le chemin de came de commande (11) sont agencés dans la zone centrale des leviers coudés (16).

5. Mécanisme d'entraînement selon la revendication 1, **caractérisé en ce que** les extrémités des leviers coudés (16), qui sont opposées à celles où se trouvent les bras (14), sont reliées aux tiges de commande (9) par l'intermédiaire de bielles (18).

6. Mécanisme d'entraînement selon la revendication 1, **caractérisé en ce que** le premier chemin de came (11) présente un tracé fermé dans la direction périphérique, de forme ondulée périodique, dont la distance radiale maximale à l'axe (A-A) permet de définir la position extrême des supports de substrat (52) par rapport à la chambre de traitement (37, 40, 41) respective.

7. Mécanisme d'entraînement selon la revendication 1, **caractérisé en ce qu'**à l'intérieur du premier chemin de came de commande (11) en position fixe, est agencé un deuxième chemin de came de commande (12) en position fixe, **en ce que** par ailleurs, sur l'agencement rotatif en forme d'étoile des bras (14) est agencé au moins une articulation de pivotement (20) sur laquelle est placé respectivement un levier coudé (21) dont une extrémité est guidée par le deuxième chemin de came de commande (12), et dont l'autre extrémité est reliée, au moyen d'une patte d'articulation (24), à la chambre de transmission (6), de façon telle qu'il soit possible de faire varier périodiquement sa vitesse périphérique en superposition à la translation radiale des supports de substrats (52).

8. Mécanisme d'entraînement selon la revendication 7, **caractérisé en ce qu'**en des endroits diamétralement opposés de l'agencement en forme d'étoile des bras (14), est agencée respectivement une articulation de pivotement (20) avec chacune un levier coudé (21) qui est relié à la chambre de transmission (6), respectivement par l'intermédiaire d'une patte d'articulation (24).

9. Mécanisme d'entraînement selon la revendication 7, **caractérisé en ce que** l'extrémité de la patte d'articulation (24) respective, qui est éloignée dudit au moins un levier coudé (21), est reliée à la chambre de transmission (6) par l'intermédiaire d'un tourillon d'articulation (25).

10. Mécanisme d'entraînement selon la revendication 9, **caractérisé en ce que** le tourillon d'articulation (25) respectif est relié, à chaque fois par l'intermédiaire d'une pièce d'angle (26) et d'une pièce conjuguée (27), à un coin voisin respectif de la chambre de transmission (6).

11. Mécanisme d'entraînement selon la revendication 1, **caractérisé en ce que** sur chacun des bras (14) tournants, est agencé au moins respectivement un émetteur de position (28) qui interagit avec des récepteurs de position (30) correspondants, en position fixe.

12. Mécanisme d'entraînement selon la revendication 11, **caractérisé en ce que** grâce aux signaux des émetteurs de position (28) et des récepteurs de position (30), il est possible de déterminer aussi bien la position angulaire de tous les bras (14), que l'affectation à l'une des chambres de traitement (37, 40, 41) ainsi qu'à la chambre de transfert (33).

13. Mécanisme d'entraînement selon la revendication 1, **caractérisé en ce que** sur la périphérie de l'axe (A-A) sont agencés, selon une répartition angulaire équidistante, quatre bras (14), une chambre de transfert (33) et trois chambres de traitement (37, 40, 41).

14. Mécanisme d'entraînement selon la revendication 1, **caractérisé en ce que** le mécanisme d'entraînement (44) avec la chambre de transmission (6), est agencé entre le fond (55) d'une partie de chambre intérieure (54) et le fond (46) d'une partie de chambre extérieure (64).

15. Mécanisme d'entraînement selon la revendication 14, **caractérisé en ce que** sur la chambre de transmission (6) sont fixées, selon un agencement croisé, quatre paires de bras horizontaux (47) sur lesquels sont suspendus des agencements de biellettes en parallélogramme (49), dont les extrémités inférieures sont reliées aux supports de substrats (52) par l'intermédiaire d'autres bras horizontaux (50).

16. Mécanisme d'entraînement selon la revendication 1, **caractérisé en ce que** les supports de substrats (52) sont orientés, vers le haut, sous un angle de 3 à 15 degrés en direction de l'axe (A-A).

17. Mécanisme d'entraînement selon les revendications 14 et 16, **caractérisé en ce que** dans la direction tangentielle à l'axe (A-A), sur la partie de chambre (64), est agencée une rangée de sas (31) linéaire, horizontale, qui est constituée par la chambre de sas d'introduction (32), de la chambre de transfert (33) et de la chambre de sas de sortie (34), à travers laquelle il est possible de faire passer les substrats sous un angle de 3 à 15 degrés.
